# EUROPEAN PATENT APPLICATION

(11) **EP 4 604 175 A1**
(43) Date of publication of application: **20.08.2025**
(21) Application number: 24158357.4
(22) Date of filing: 19.02.2024
(51) Int. Cl.: H01L 21/8234, H01L 29/417, H01L 23/528, H01L 27/088, H01L 29/06, H01L 29/775

(54) **A METHOD OF FABRICATING A FIELD-EFFECT TRANSISTOR STRUCTURE**

(71) Applicant: Huawei Technologies Co., Ltd., Shenzhen, Guangdong 518129 (CN)
(72) Inventor: Yakimets, Dmitry, 80992 Munich (DE); Bhuwalka, Krishna Kumar, 80992 Munich (DE)
(74) Representative: Roth, Sebastian

(57) **Abstract**

The present disclosure relates to a method of fabricating a field-effect transistor, FET, structure, and to a FET structure obtainable by said method. The method comprises the steps of: forming a first fin structure (11) on a first side of a substrate (10), wherein the first fin structure (11) extends along a channel direction, and wherein the first fin structure comprises at least one first channel (12); forming a shallow trench isolation, STI, layer (13) on the first side of the substrate (10), wherein the STI layer (13) is arranged on opposite sides of the first fin structure (11); forming a first source and/or drain structure (21) along the first fin structure (11), wherein the first source and/or drain structure (21) electrically contacts the at least one first channel (12); etching a recess (25) from a second side of the substrate (10), which is opposite to the first side, wherein the recess (25) passes through a section of the STI layer (13), and wherein the recess (25) reaches the first source and/or drain structure (11); and filling the recess (25) with an electrically conductive material to form a via (26), wherein the via (26) is in contact with the first source and/or drain structure (21).

## Description

### TECHNICAL FIELD

The present disclosure relates to a method of fabricating a field-effect transistor (FET) structure.

### BACKGROUND

Transistors are an integral part of any integrated circuit for mobile or high-performance computer applications. Currently, a transition takes place from fin field-effect transistors (FinFET) to nanosheet (NS) transistor designs. A FinFET is a type of 3D transistor, where the gate is placed on two or more sides of a fin-like structure which protrudes from the surface of a silicon substrate and which forms the channel. NS transistors are an evolution of this FinFET design and use a series of horizontal sheets or layers of semiconductor material stacked on top of each other. These sheets form the channel of the transistor.

Power delivery to transistors has become an issue because of continuous scaling of metal wires. A recent solution to this issue is the so-called backside power delivery network (BS-PDN) which utilizes thicker metal wires. Yet, it is arranged on the backside of the substrate and needs to be contacted to the transistors through the substrate

Possible ways to contact a BS-PDN to transistors on the front side rely on through-silicon-via middle (TSVM) connections or buried power rails. However, in both arrangements some silicon area is required to propagate current from the BS-PDN to the bottom-most metal layers on the front-side of the substrate, thus causing some area penalty. An alternative approach for power delivery is a direct backside connection (BSC) which is, however, difficult to realize. Currently, most proposed ways to enable BSC rely on sacrificial dielectric plugs underneath a source/drain. In addition to being difficult to realize from an integration point of view, conventional BSC designs can negatively affect the transistor performance. For instance, the BSC can reduce the mechanical stress in the transistors which leads to a degradation of their performance. This is, e.g., due to the source/drain epi only growing from the sides of a channel, but not from the substrate.

### SUMMARY

In view of the above, this disclosure aims to provide an improved method of fabricating a FET structure, which overcomes the above-mentioned limitations and disadvantages.

These and other objectives are achieved by the solution of this disclosure as described in the independent claims. Advantageous implementations are further defined in the dependent claims.

A first aspect of this disclosure provides a method of fabricating a field-effect transistor (FET) structure. The method comprises the steps of: forming a first fin structure on a first side of a substrate, wherein the first fin structure extends along a channel direction, and wherein the first fin structure comprises at least one first channel; forming a shallow trench isolation (STI) layer on the first side of the substrate, wherein the STI layer is arranged on opposite sides of the first fin structure; forming a first source and/or drain structure along the first fin structure, wherein the first source and/or drain structure electrically contacts the at least one first channel; etching a recess from a second side of the substrate, which is opposite to the first side, wherein the recess passes through a section of the STI layer, and wherein the recess reaches the first source and/or drain structure; and filling the recess with an electrically conductive material to form a via, wherein the via is in contact with the first source and/or drain structure.

In this way, the source and/or drain structure can be electrically connected to the backside of the substrate by means of the via, which runs (partially) through the STI layer, and which can be formed laterally displaced to the fin structure (i.e., not centered). This allows contacting the source and/or drain (S/D) structure from the backside and, at the same time, having a bigger contact surface and/or preserving stress. As vias run (at least partially) through the STI layer, a single via could be used for contacting S/D structures of two neighboring fins.

The channel direction is parallel to the substrate, i.e. parallel to a surface of the substrate.

The recess can be a hollow channel (i.e., an empty via) or through-hole which runs from the second side to the first side of the substrate. Thus, after filling the recess with the electrically conductive material, an electrical connection is established between the second side of the substrate and the source and/or drain structure on the first side.

All statements with regard to the arrangement of the recess (e.g., relative to other components and layers, such as the STI layer or the fin structure) can hold true for the via after the filling of the recess.

The FET structure can be a FinFET structure.

The at least one channel can be at least one channel layer. Thus, the FET structure can also be a NS structure respectively a NSFET structure.

The method can comprise forming a first source structure and forming a first drain structure along the first fin structure, wherein the source and drain structures are different structures. Depending on the design and/or type of the FET structure, a single structure could also serve as a both source and drain structure of a transistor. The recess can reach the first source and/or the first drain structure through the substrate and the STI layer, and the via can be in contact with the first source and/or with the first drain structure.

In an implementation form of the first aspect, the method further comprises the step of: electrically connecting the electrically conductive material with a signal or power metallization, which is formed on the second side of the substrate.

The signal or power metallization can comprise signal and/or power lines. The signal or power metallization can comprise or can form a BS-PDN.

In an implementation form of the first aspect, the via is laterally offset from the first fin structure. For instance, this allows increasing the contact surface between the conductive material in the via and the source and/or drain structure. Furthermore, this allows contacting source and/or drain structures on more than one fin structure with a single via.

In an implementation form of the first aspect, the recess reaches the first source and/or drain structure on two separate positions. Thus, the via can electrically contact the first source and/or drain structure on two separate positions, e.g. on two opposite sides of the fin structure to form a double-sided contact.

In an implementation form of the first aspect, the method comprises the further step of: forming a metallization structure which at least partially surrounds the first source and/or drain structure, wherein the electrically conductive material is in electrical contact with the metallization structure. This provides the advantage of improving the electrical contact from the via to the source and/or drain structure.

In an implementation form of the first aspect, the first source and/or drain structure is formed by: forming a cavity in the first fin structure, wherein the cavity interrupts the at least one channel in a determined location along the channel direction, and forming the first source and/or drain structure in the cavity. For instance, the cavity can be a further recess.

In an implementation form of the first aspect, the first source and/or drain structure is formed by an epitaxial growth process.

In an implementation form of the first aspect, a confinement structure is formed around the determined location, wherein the confinement structure limits the epitaxial growth of the source and/or drain structure. This provides the advantage of facilitating the epi growth of the source and/or drain structure. The confinement structure can be formed by an epi wall structure.

In an implementation form of the first aspect, the recess further passes through a section of the first fin structure below the at least one channel.

For instance, the recess respectively the resulting via partially passes through the STI layer and partially passes through a bottom region of the fin structure (below the channel).

In an implementation form of the first aspect, a portion of the first fin structure between the recess and the first source and/or drain structure stays intact.

For example, the recess does not reach the channel through the first fin structure, i.e. a part of the first fin structure material below the channel stays intact. For instance, in a first step the fin structure is etched up to a point where the STI layer is sufficiently exposed; then the STI layer is etched in a second step, such that the resulting via contacts the source and/or drain structure through the STI layer. The etch depth of the first etch may be controlled in different ways, such as: stopping on an etch stop layer (e.g. SiGe) underneath a fin, by time-based etching, or by stopping on the STI surface itself.

The recess can be formed by a plurality of etching steps. For example, in a first of the etching steps, material (e.g., Si) of the first fin structure is removed; and, in a second of the etching steps, material of the STI layer is removed.

In an implementation form of the first aspect, the STI layer comprises an etch stop structure which limits a lateral expansion of the recess in the STI layer. The etch stop structure can be formed from a material in which the etchant used for forming the recess has a low etching rate.

In an implementation form of the first aspect, the method further comprises: forming at least a second fin structure on the first side of a substrate, wherein the second fin structure extends along the channel direction and comprises at least one second channel; wherein the second fin structure is arranged at a distance to the first fin structure, and wherein the second fin structure is electrically isolated from the first fin structure by the STI layer; forming a second source and/or drain structure along the second fin structure, wherein the second source and/or drain structure electrically contacts the at least one second channel; wherein the recess additionally reaches the second source and/or drain structure.

Thus, after filling of the recess, the via reaches and electrically contacts both the first and the second source and/or drain structure.

The at least one second channel can be at least one second channel layer.

In an implementation form of the first aspect, the via is centrally arranged between the first fin structure and the second fin structure.

In an implementation form of the first aspect, the first source and/or drain structure and the second source and/or drain structure are physically separated. In other words, the first source and/or drain structure and the second source and/or drain structure do not have direct physical contact with each other. This can increase the contact area from the via and/or a metallization structure to both source and/or drain structures.

In an implementation form of the first aspect, the metallization structure at least partially surrounds the first source and/or drain structure and the second source and/or drain structure.

In an implementation form of the first aspect, a plurality of the second fin structures is formed, wherein the first fin structure and the plurality of second fin structures are arranged in parallel on the first side of the substrate; wherein the recess reaches a respective source and/or drain structure of the first and of each second fin structure, or wherein a respective recess is formed between each two adjacent fin structures of the first and the second fin structures.

The respective recess between each two adjacent fin structures can be filled with the electrically conductive material to form a respective vias.

Thus, there can be one big via formed connecting to all source and/or drain structures. Alternatively, if N fin structures are arranged in parallel, N-1 vias can be formed, each via connecting to two fin structures.

A second aspect of this disclosure provides a field-effect transistor (FET) structure obtainable by the method according to first aspect of this disclosure.

### BRIEF DESCRIPTION OF DRAWINGS

The above described aspects and implementation forms will be explained in the following description of specific embodiments in relation to the enclosed drawings, in which:
- FIGS. 1-26: show a process flow of a method of fabricating a FET structure according to an embodiment; and
- FIG. 27: shows a schematic diagram of a FET structure according to an embodiment.

### DETAILED DESCRIPTION OF EMBODIMENTS

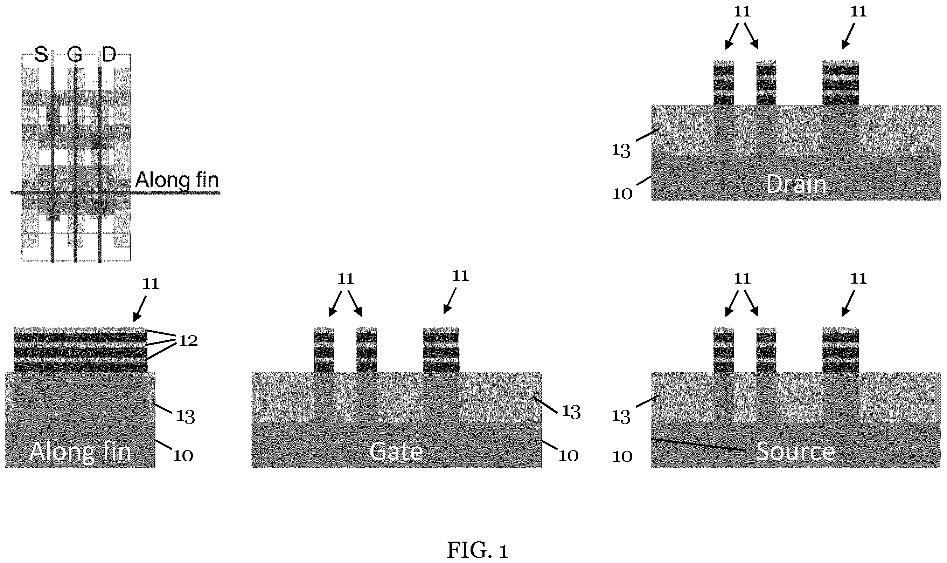

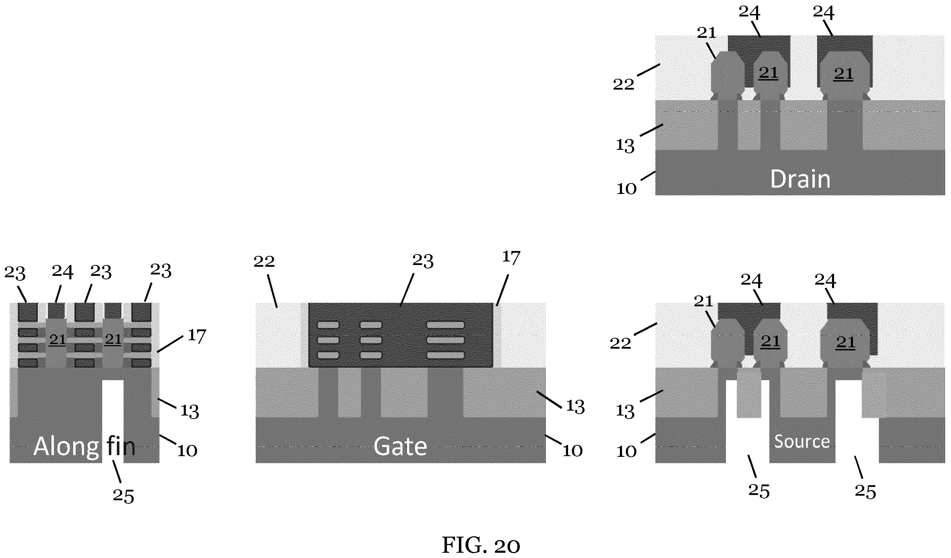

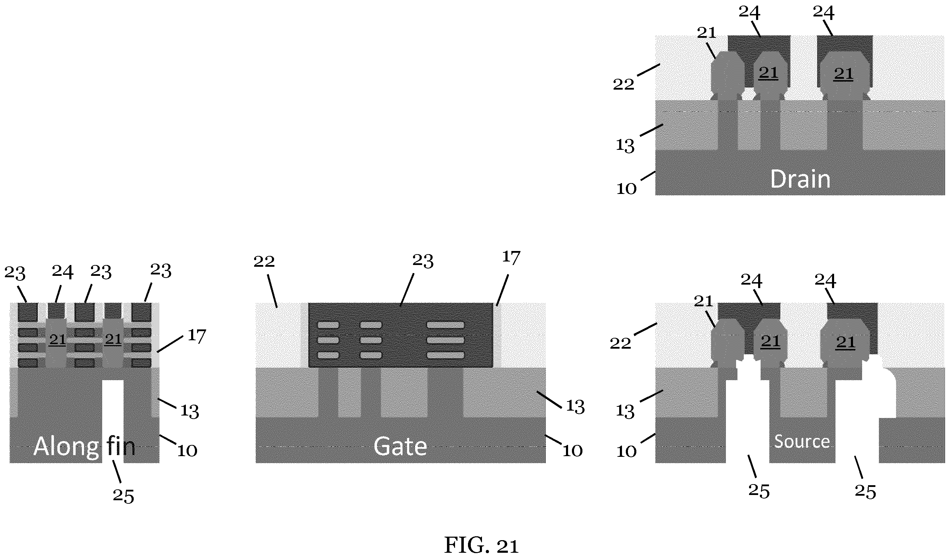

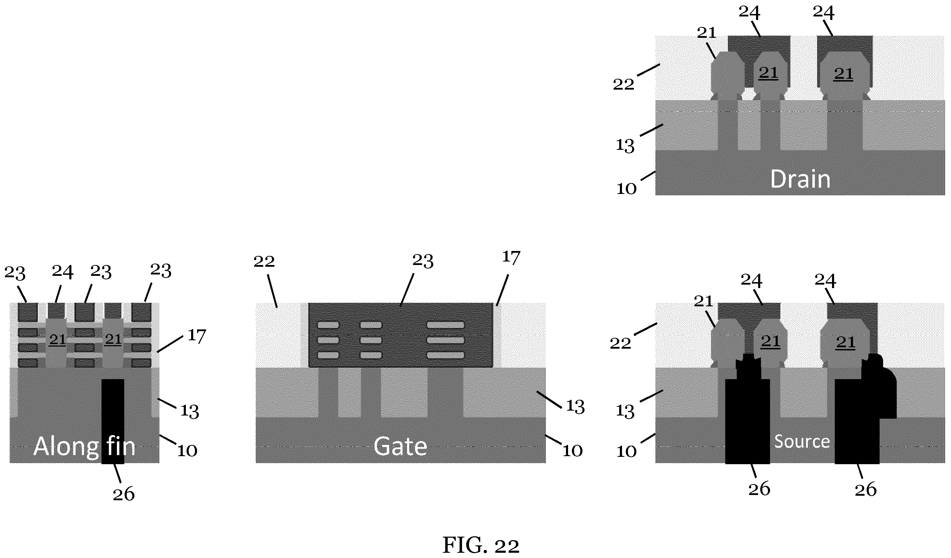

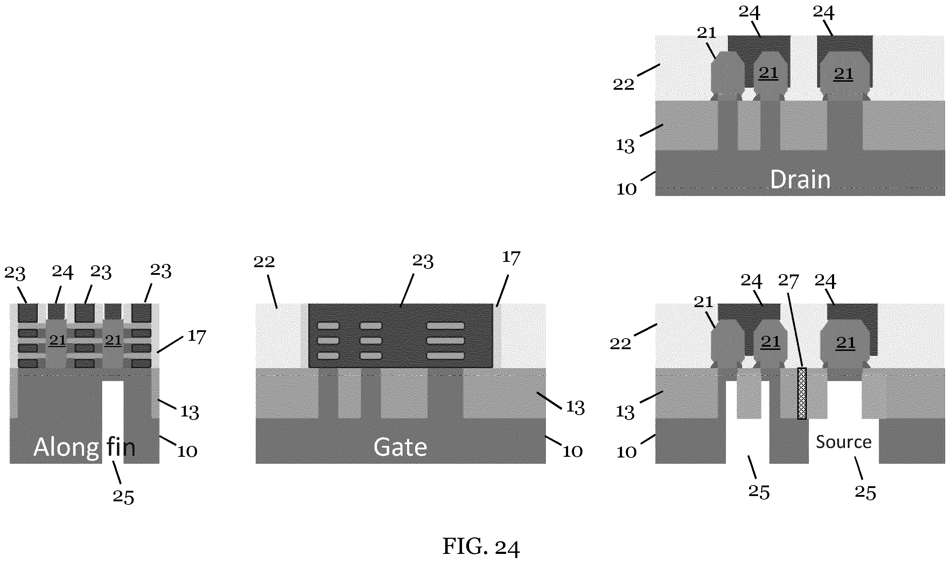

FIGS. 1-26 show a process flow of a method of fabricating a FET structure according to an embodiment. Thereby, each of FIGS. 1-26 shows four cross-sectional views of the FET structure to be fabricated: along a fin structure (bottom left image), along a gate structure (bottom center image), along a source structure (bottom right image) and along a drain structure (top right image). The positions of these cross-sections relative to an exemplary fabricated FET structure are indicated in the top left image in FIG. 1, which shows a top view of the FET structure with respective section lines.

This exemplary FET structure features an inverter layout with a PMOS comprising two fin structures 11 and an NMOS comprising one fin structure 11. However, this structure just serves as an example and any other single fin or multi fin FET structure could be fabricated with this process flow.

In a first step, shown in FIG 1, a first fin structure 11 (e.g., the left fin structure in the source, drain and gate cross-sections) is formed on a first side of a substrate 10, wherein the first fin structure 11 extends along a channel direction, and wherein the first fin structure 11 comprises at least one first channel 12. The fin structure 11 can be formed by fin patterning.

Furthermore, a shallow trench isolation (STI) layer 13 is formed on the first side of the substrate 10, wherein the STI layer 13 is arranged on opposite sides of the first fin structure 11.

As shown in FIG. 1A, a plurality of fin structures 11 can be formed on the substrate, which can define an epi superlattice formation. In the example shown in FIG. 1, a second fin structure 11 (e.g., the middle fin structure in FIG. 1) and a third fin structure 11 (e.g., the right fin structure in FIG. 1) are formed on the first side of a substrate, wherein the second and the third fin structure 11 each extend along the channel direction and comprise at least one second channel. For example, the first and second fin structure 11 are used for forming a PMOS structure (multi fin device) and the third fin structure 11 is used for forming an NMOS structure (single fin device). However, this is just an example and any number of additional fin structures at different arrangements relative to each other could be formed on the substrate 10, depending on which FET structure is fabricated.

The fin structures 11 can each be arranged at a distance to each other and two neighboring fin structures 11 can be electrically isolated from each other by the STI layer 13.

As shown in FIG. 1, the channels 12 in the fin structures 11 can be channel layers, e.g. nanosheets, such that the resulting FET structure is a nanosheet structure. However, it is also possible that each fin structure comprises only one channel and the FET structure is a FinFET.

The channel direction can be parallel to the substrate 10 (i.e., to a surface of the substrate 10).

The channel layers 12 can be silicon layers which are alternately arranged with other material layers, e.g. SiGe layers.

The substrate 10 and the bottom part of the fin structure(s) 11 (below the channel layers) can be formed from silicon.

The STI layer 13 can be formed from an electrically insulating material, such as silicon dioxide. For instance, the STI layer 13 is deposited on the substrate via a suitable deposition process.

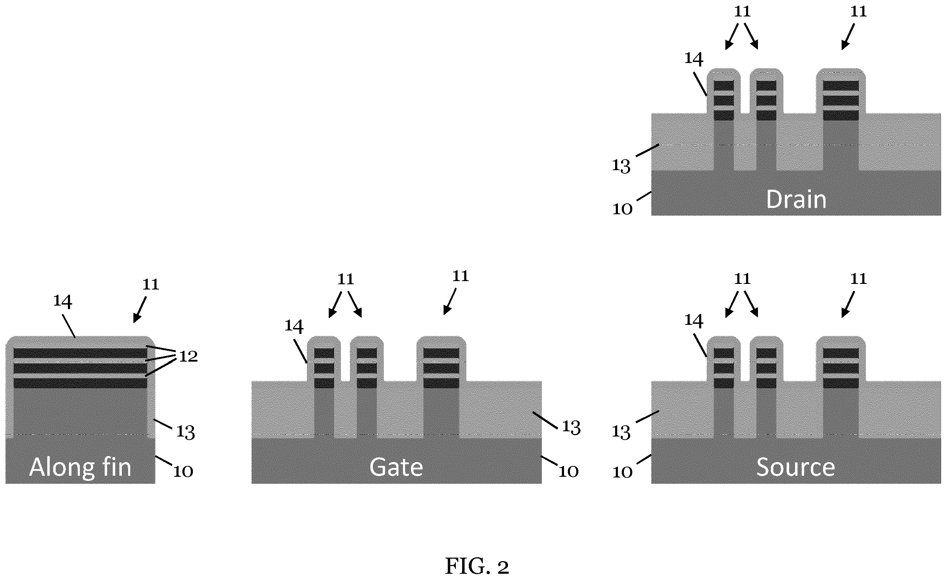

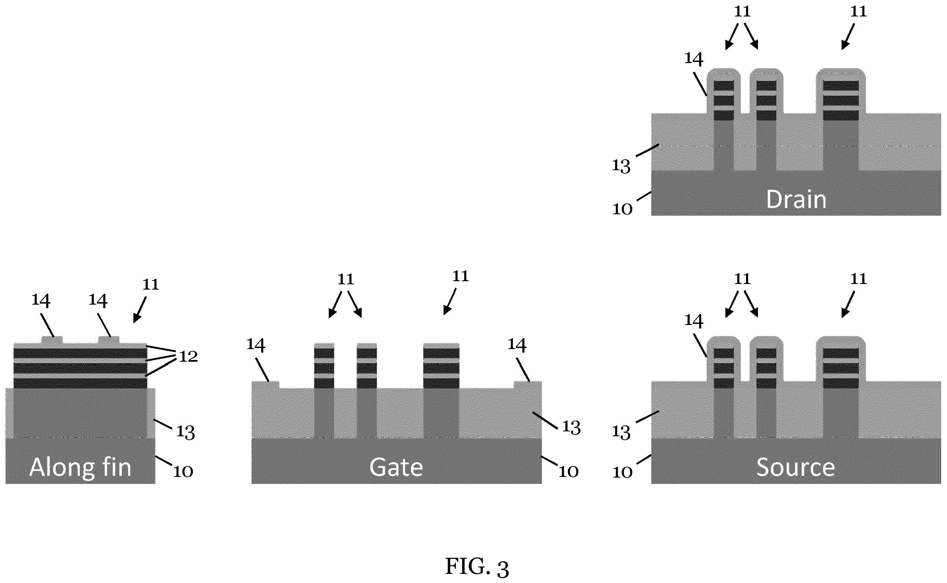

Subsequently, as shown in FIGS 2 and 3, an optional sacrificial spacer layer 14 can be deposited on the fin structure(s) 11 and the STI layer 13. The sacrificial spacer layer 14 can then be selectively removed using a gate mask (cf., FIG. 3).

The goal is to selectively remove the sacrificial spacer layer 14 from a gate region (i.e., the region where the dummy gate structures 23 respectively the gate structures will be formed around the channel 12 in a later step). Only the source and drain regions (and, e.g., extensions) should be covered with the spacer layer 14.

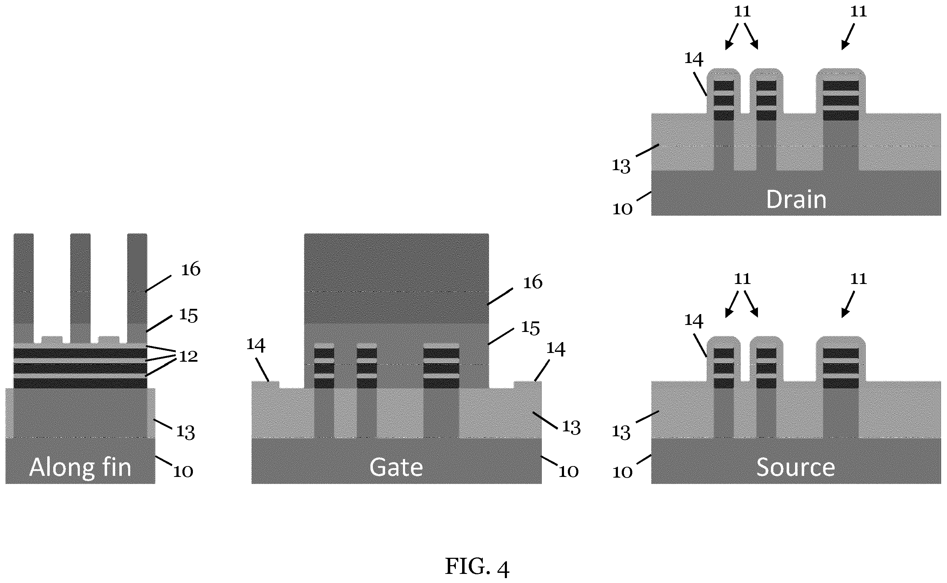

In a subsequent step, shown in FIG. 4, the gate region can be patterned with a poly Si layer 15 and a hard mask 16 which e.g. facilitates the formation of a gate cut structure.

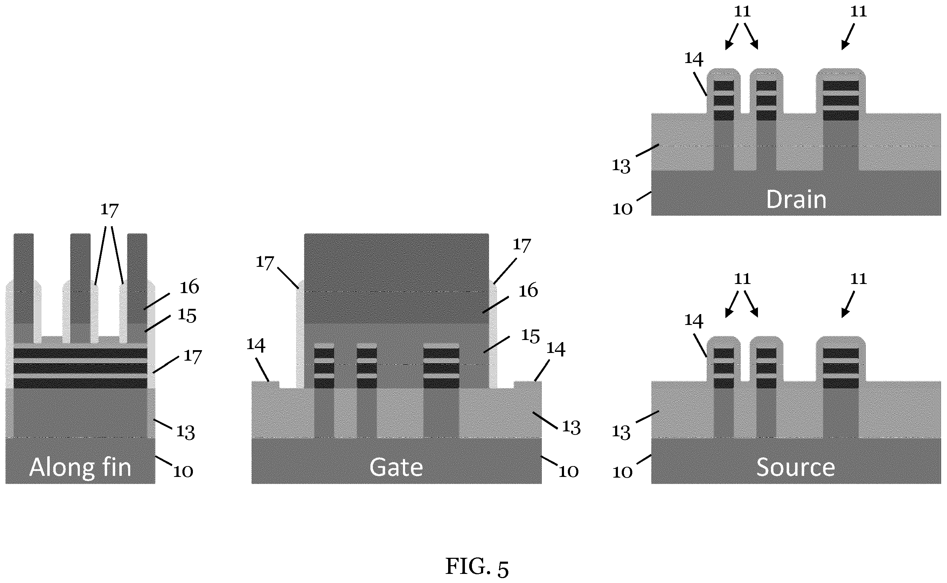

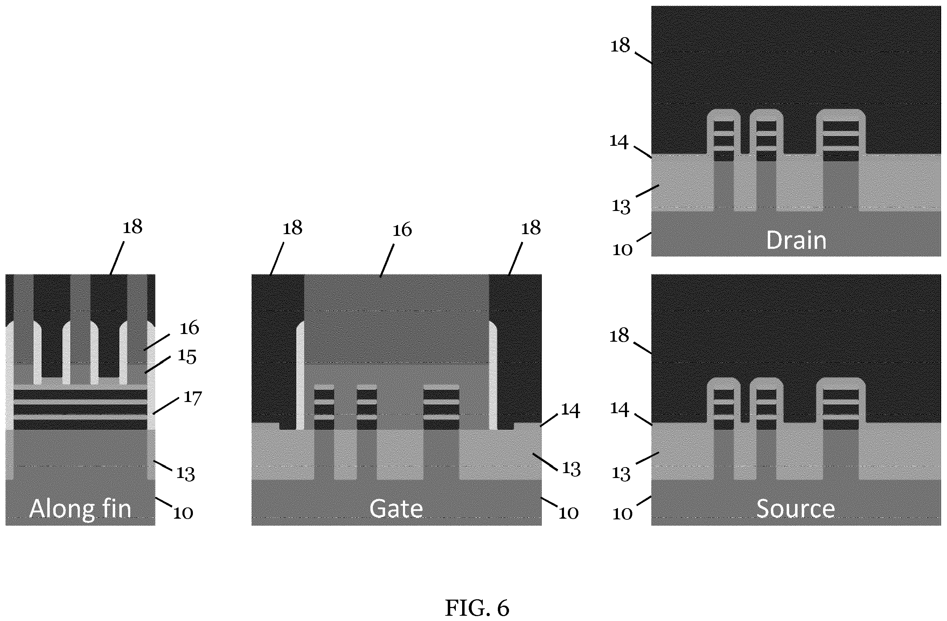

Then, as shown in FIG. 5, a main spacer 17 can be deposited on side surfaces of the poly Si layer 15 and hard mask 16 and an etchback can be carried out. An epi wall structure 18 (e.g., an epitaxial material layer) can then be deposited to fill the remaining cavities between the poly Si layer 15 and hard as shown in FIG. 6.

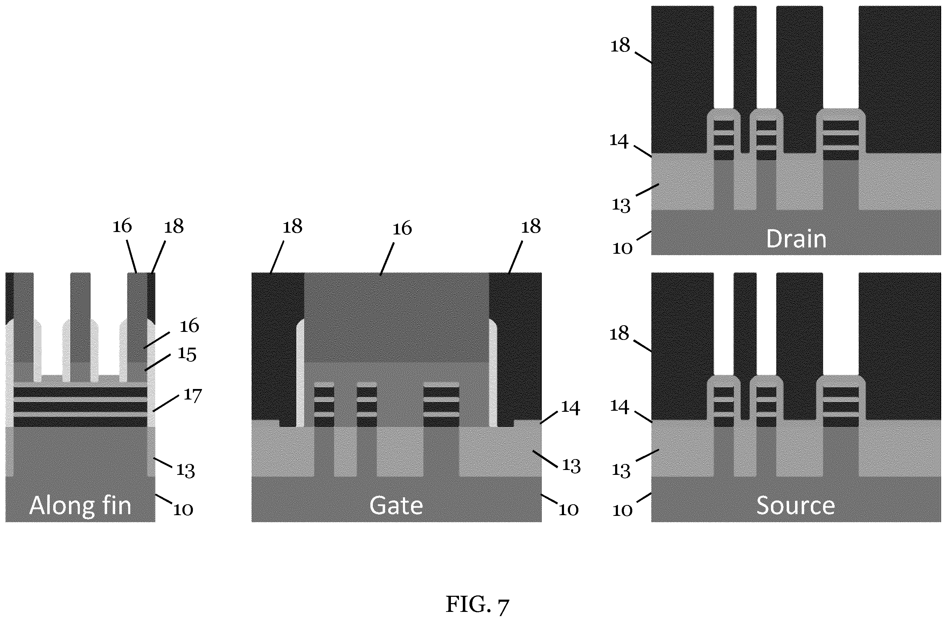

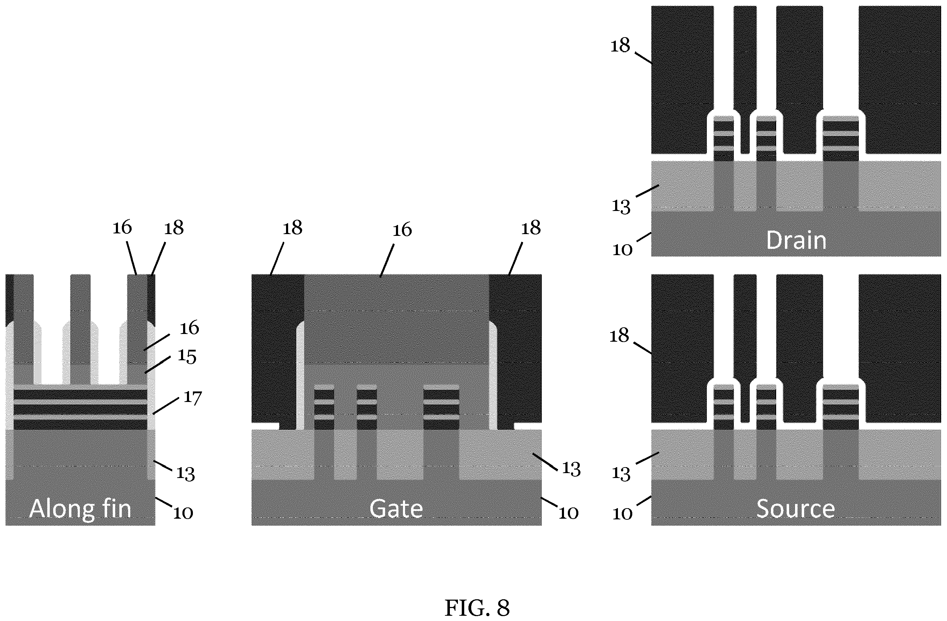

At the locations of the later source and/or drain structures, openings can be etched into the epi wall structure 18, e.g. using a fin mask, as shown in FIG. 7. Then, the sacrificial spacer layer 14 can be removed, as shown in FIG. 8.

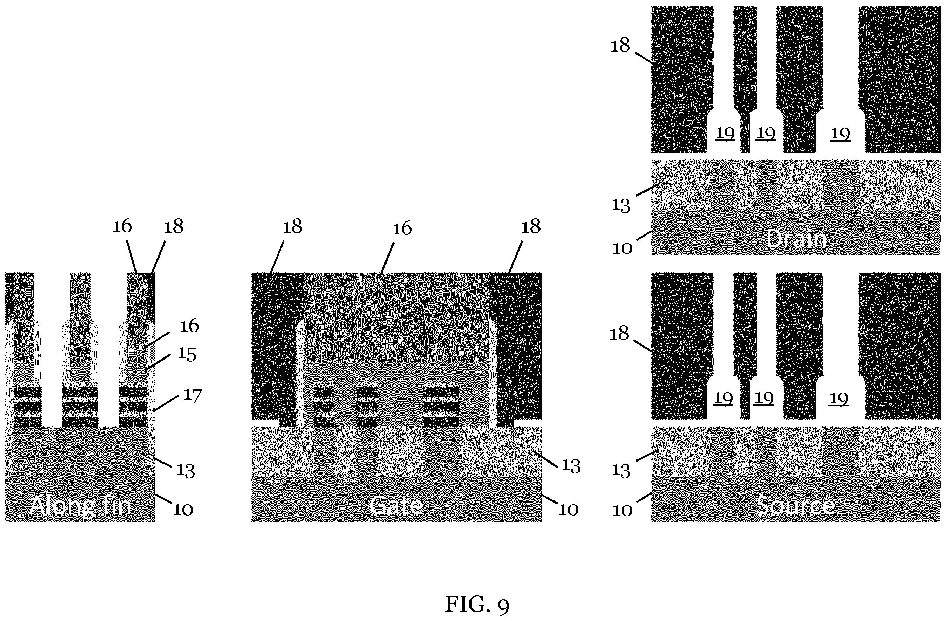

Then, as shown in FIG. 9, the openings in the epi wall structure 18 can be used to selectively recess portions of the fin structures 11 at the source and/or drain regions (i.e., the regions where the source and/or structures will be formed in a later step).

In this way, cavities 19 can be formed in the respective fin structure(s) 11, wherein each cavity 19 interrupts the at least one channel 12 of the fin structure 11 in a determined location (e.g., the source or drain region) along the channel direction.

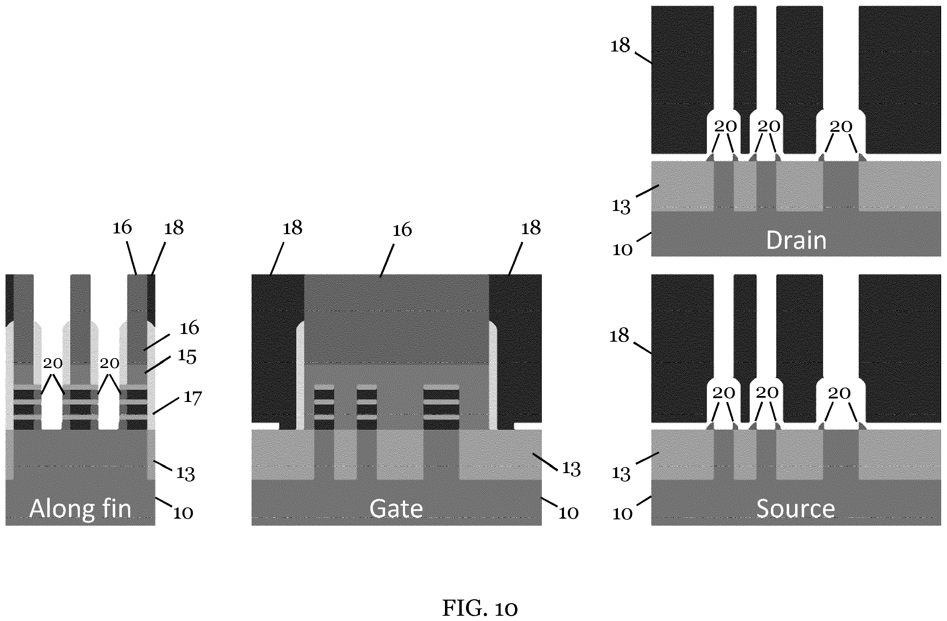

Subsequently, as shown in FIG. 10, inner spacers 20 can be formed in a bottom region and on a side surface of the "cut" fin structures 11, especially between the channels (as can be seen in the bottom left image in FIG. 10).

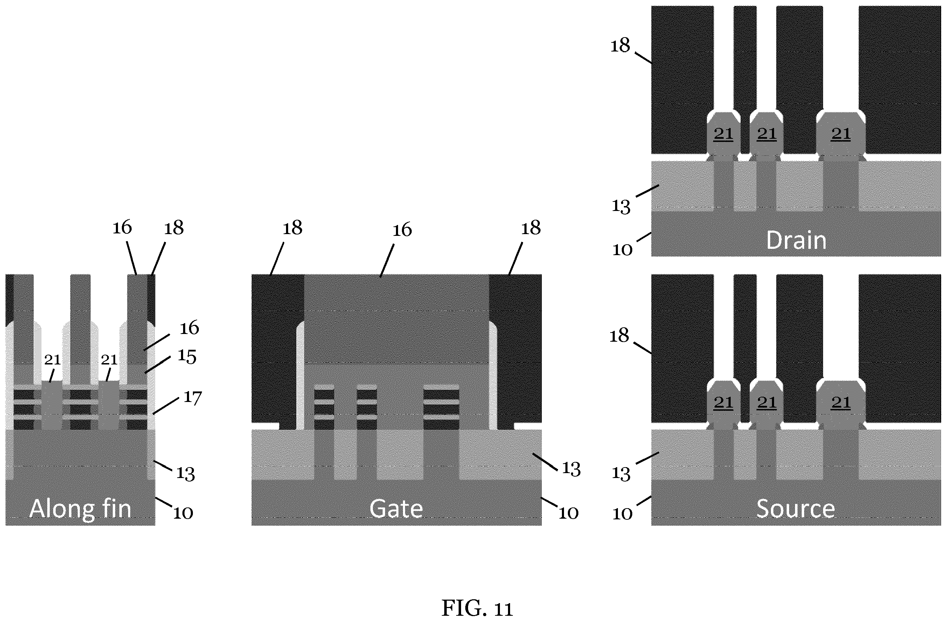

FIG. 11 shows a formation of source structures 21 and/or drain structures 21 along the respective fin structure(s) 11. Thereby, the source and/or drain structures 21 can be formed to electrically contact the respective channel(s) 12 of the fin structure(s) 11.

For instance, the source structures 21 are formed in the cavities 19 in the source region (bottom right image) and the drain structures 21 are formed in the cavities 19 in the drain regions (top right image).

Thereby, the remaining epi wall structure 18 around the cavities 19 can form a so-called confinement structure which confines the growth of the source and/or of the drain structures 21. This confinement structure can thus limit an epitaxial growth of the source and/or drain structures 21 at their respective locations.

The source and/or the drain structure(s) 21 can be formed by an epitaxial growth process. Thereby, NMOS and PMOS epi structures can be grown.

Typically, a sourced/drain epitaxy process (S/D epi) would not be confined in space. However, the epi wall structure 18 (i.e., the confinement structure) can enable a confined epitaxial growth of S/D structures which facilities the formation of a wrap-around contact. For instance, an S/D epi induces mechanical stress into a channel improving its electrical characteristics, wherein the amount of stress is linked to the volume of the epi structures. The sacrificial spacer layer 14 and the epi wall structure 18 can be used to control volume of the source and/or drain structures 21 and keep their growth confined. For instance, the size (e.g., thickness) of the removed sacrificial spacer layer 14 controls a lateral extension of the source and/or drain structures 21 and the epi wall structure 18 (also: confinement wall) limits the actual S/D growth.

Furthermore, the source and/or drain structures 21 can be formed to be physically separated from each other. This can also be controlled by the exact arrangement of the epi wall structure 18. For instance, even though the first and the second fin structure 11 (left and middle) are relatively close to each other, a short section of the epi wall structure 18 can be arranged between these fin structures 11, which prevents a merging of a (first) source respectively drain structure 21 around the first fin structure 11 and a (second) source respectively drain structure 21 around the second fin structure 11.

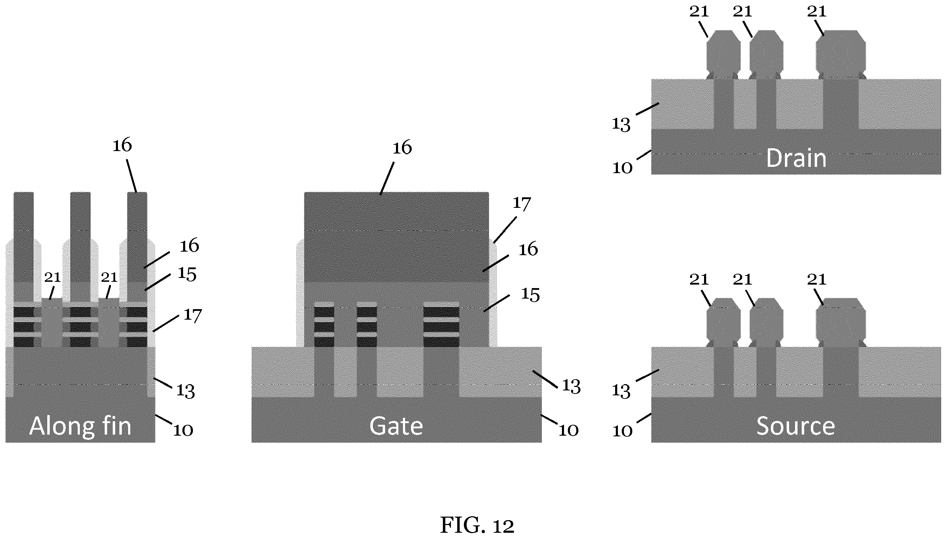

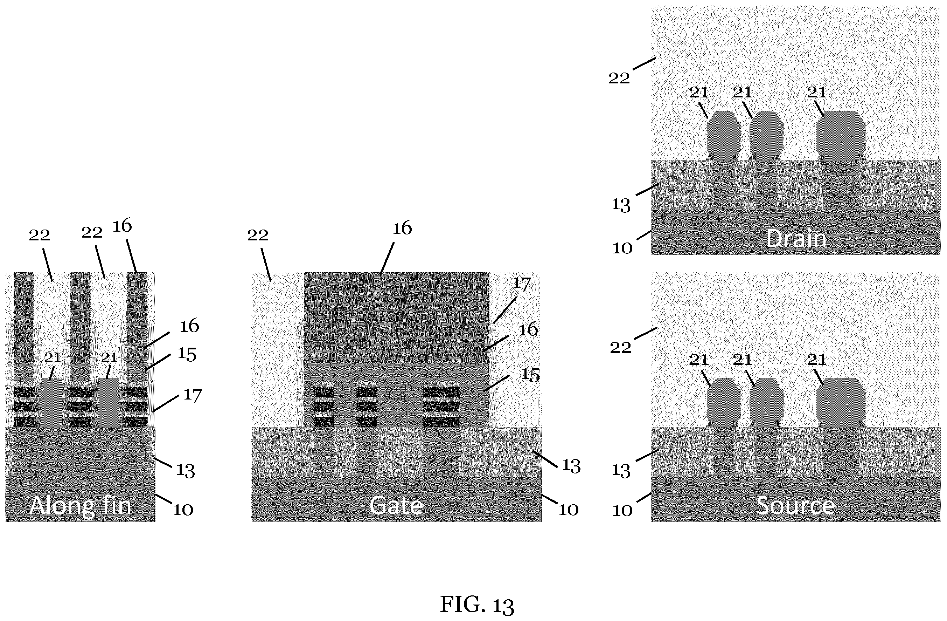

Subsequently, as shown in FIG. 12, the epi wall structure 18 can be removed, and the freed-up space can be filled with a zero-level interlayer dielectric (ILD0) layer 22 (cf., FIG 13).

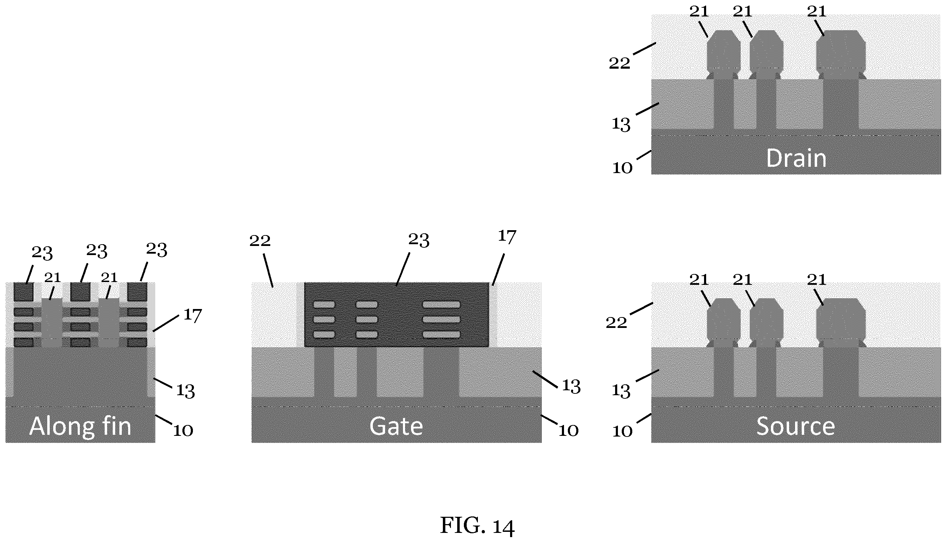

Then, as shown in FIG. 14, the ILD0 dielectric layer 22 and the hard mask 16 can be recessed from the top and the poly Si layer 15 can be removed. A dummy gate structure 23 can be formed in the gate region. The dummy gate structure 23 can be fabricated via a replacement metal gate (RMG) module process and can facilitate a later formation of a gate structure at the same location.

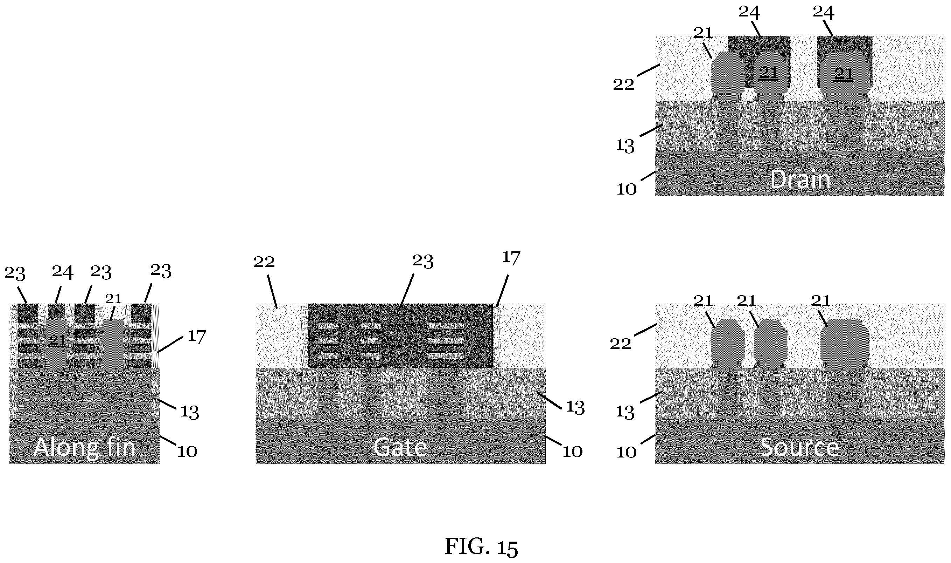

The subsequent FIGS. 15 to 18 show a first alternative of the method, were metallization structures 24 are only formed at the drain structures 21 but not at the source structures 21.

FIG. 15 shows the optional formation of the metallization structures 24, which can at least partially surround the drain structures 21. The metallization structures 24 can be formed from an M0 metal layer.

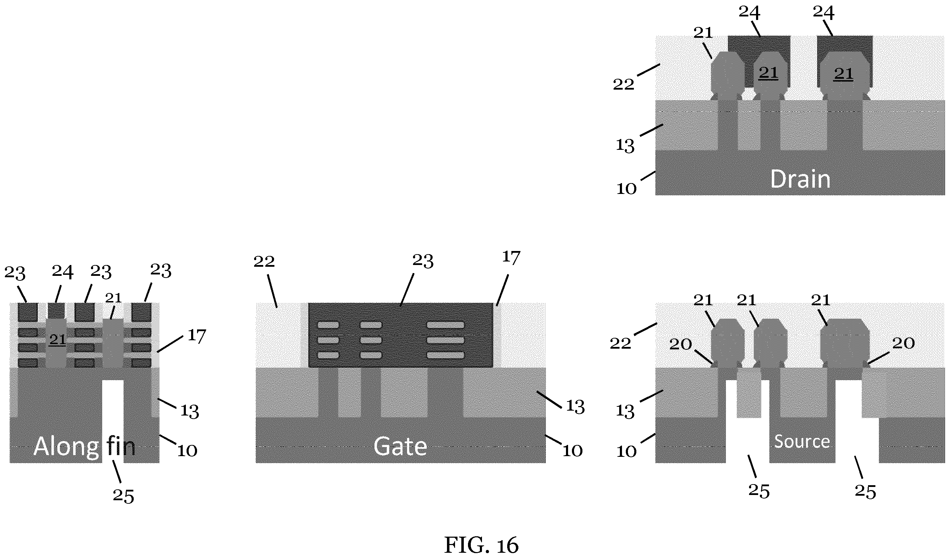

Fig. 16 shows a subsequent step of etching at least one recess 25 from a second side of the substrate 10, which is opposite to the first side of the substrate 10.

Each recess 25 can be generated as an (empty) channel or a through-hole which connects the fin structures 11 on the first side to the second side of the substrate 10.

The formation of the recess 25 can be a step in a back-side processing of the FET structure. In conjunction with this back-side processing, a few extra steps which are not shown in the process flow of FIGS. 1 to 26 can be carried out:
1) A full front-side metallization can be completed first (e.g. metal 1, 2, 3, X metallizations). Our example shows only a metal 0 (M0) metallization which is the lowest level, as it is the most relevant for the present disclosure. But there may be 12-14 layers.
2) A carrier wafer can be bonded on top of the wafer which forms the substrate 10.
3) The wafer can be flipped for starting the back-side processing.
4) The original wafer can be thick. Thus, it can be first grinded and afterwards, polished with CMP. This allows to reduce original substrate 10 thickness and enables the subsequent steps. The recess 25 mentioned below is difficult for an originally thick wafer, thus it can be thinned first as described above.

In the example shown in FIG. 16, a single recess 25 is etched below the first and the second fin structure 11 (left and middle fin structures). This recess can be arranged centrally between the fin structures 11. The third (right) fin structure 11 can have its own recess 25. In each case, the respective recess 25 can be laterally offset from the fin structure(s) 11 it connects to.

As shown in the bottom right image in FIG. 16, a respective recess 25 can further pass through a section of a fin structure 11 below its channel (layers) 12. Thereby, a portion of the fin structure 11 material (e.g., Si) between the recess 25 and the first source structure 21 can stay intact, such that the recess 25 does not reach the source structure 21 directly through the fin structure 11.

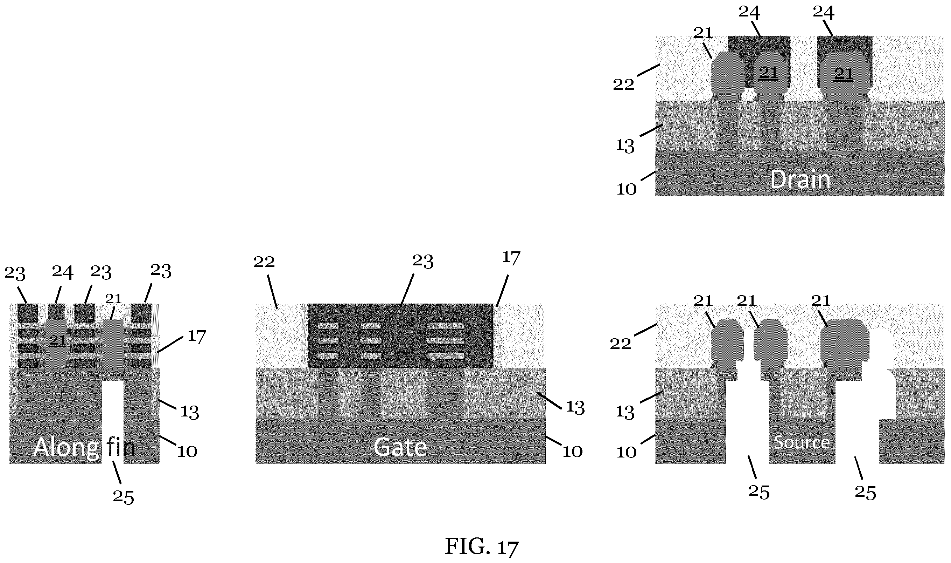

In a subsequent step, shown in FIG. 17, the recesses 25 are further etched through a section of the STI layer 13 to reaches the respective source structures 21. For instance, each recess reaches the source structure 21 from the side (and not directly from the bottom through the fin structure 11). In addition to the STI layer 13, also the I1D0 dielectric layer 22 can be etched in this step to reach the sides of the S/D epi.

Thus, the resulting recess 25 can be formed in a two-step process: in a first step the fin structure 11 can be etched up to a point where the STI layer 13 is sufficiently exposed (cf., FIG 16); and in a second step the STI layer 13 is etched, such that the resulting recess reaches the source structure (cf., FIG. 17). The first etch may be done in different ways, such as: stopping on an etch stop layer (e.g. SiGe) underneath a fin structure 11 (or more specifically, underneath the channel(s) of a fin structure 11), by time-based etching, or by stopping on the STI layer surface itself.

For instance, the "central" recess 25 below the first and second fin structure 11 can reach the source structures 21 of both fin structures 11, such that a single through-connection to two source structures 21 is established.

Besides the STI layer 13, the recess(es) 25 can also etch away any inner spacers residuals 20 from the S/D regions.

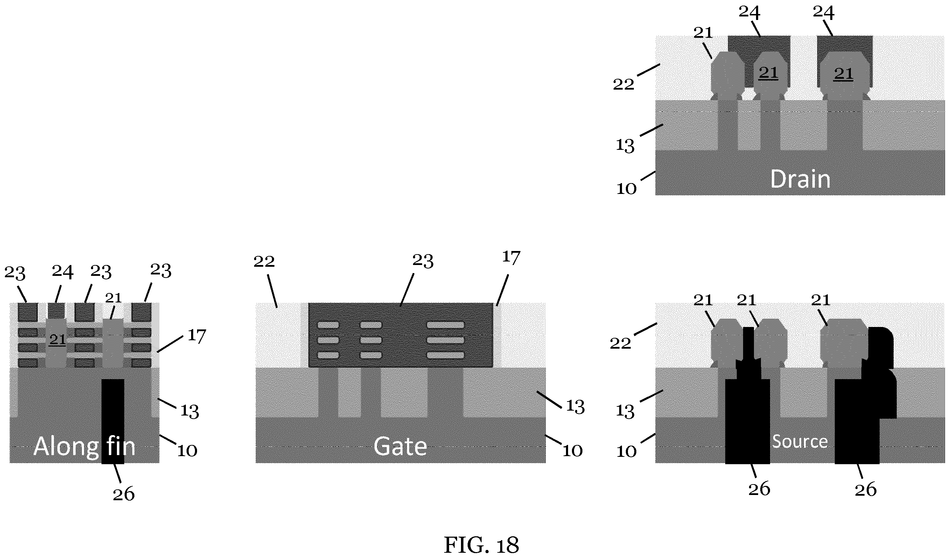

In a subsequent step, shown in FIG. 18, the recesses 25 are filled with an electrically conductive material to form respective vias 26, wherein each via 26 respectively its electrically conductive material is in contact with at least one source structure 21. Thus, the vias 26 can form a back-side contact (BSC) which can connect the source structures 21 on the front side of the substrate 10 to signal or power lines on the backside of the substrate 10.

The electrically conductive material can be a metal which is filled in the recesses 25 from the second side of the substrate (e.g., a backside metal).

In the example shown in FIG. 18, a central via 26 is formed between the first and second fin structure 11. This central via 26 electrically contacts the source structures 21 of both fin structures 11, e.g. from the side. This achieves a relatively large contact surface with both source structures. Furthermore, a single via 26 can be formed for multiple fin structures 11. In contrast, a separate via 26 is formed below the third fin structure 11 (right fin structure), which contacts the source structure 21 on the third fin structure 11 from the side.

The vias 26 can form a connection to the source structures 21 through the STI layer 13. Therefore, no separate sacrificial dielectric plug is required underneath the source/drain epi. Furthermore, by contacting the source structures 21 through the STI layer 13, source regions right underneath the fins can remain intact preserving mechanical stress and ensuring channel integrity. Connection through the STI layer 13 can be especially beneficial for multi-fin transistors ensuring good contact resistance across all the fins.

Alternative arrangements of the via(s) 26 are possible. For instance, one large recess 25 (and thus via 26) could be formed which connects to a plurality of source and/or drain structures 21 at once. Alternatively, there could be N-1 vias 26, each via 26 being centrally arranged between N fins structures 11, and each via 26 connecting to two adjacent source and/or drain structures 21.

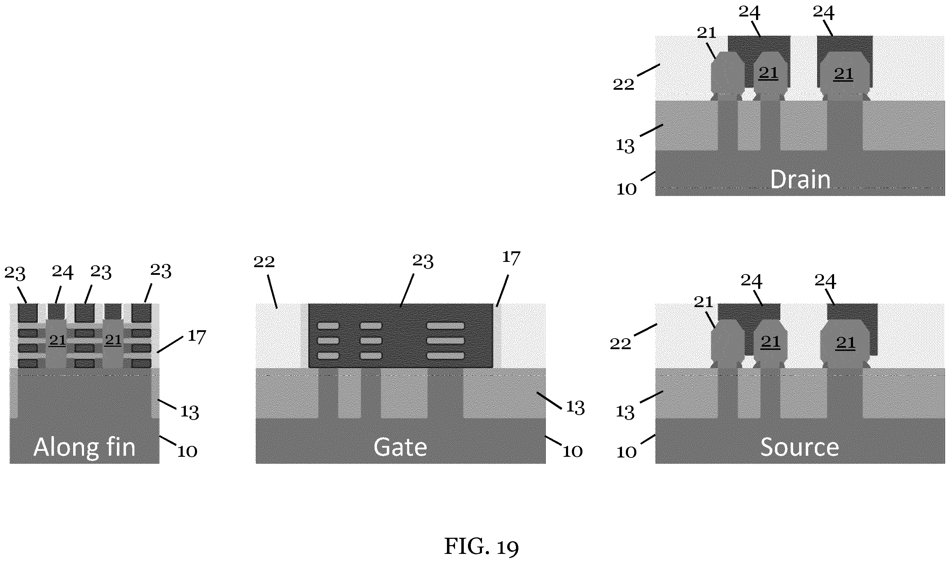

The FIGS. 19 to 23 show a second alternative of the method, were the metallization structures 24 are formed at least partially around the source and the drain structures 21. This can result in the electrically conductive material in the vias 26 being in electrical contact with the metallization structures 24 around the source structures 21, which can enhance a contacting area leading to a reduced contact resistance.

In addition or alternatively, metallization may take place from the back side (second side of the substrate 10) reducing parasitic capacitance at the expense of contact resistance. The back-side side metallization can be connected to the front-side metallization structures 24 by means of the vias 26.

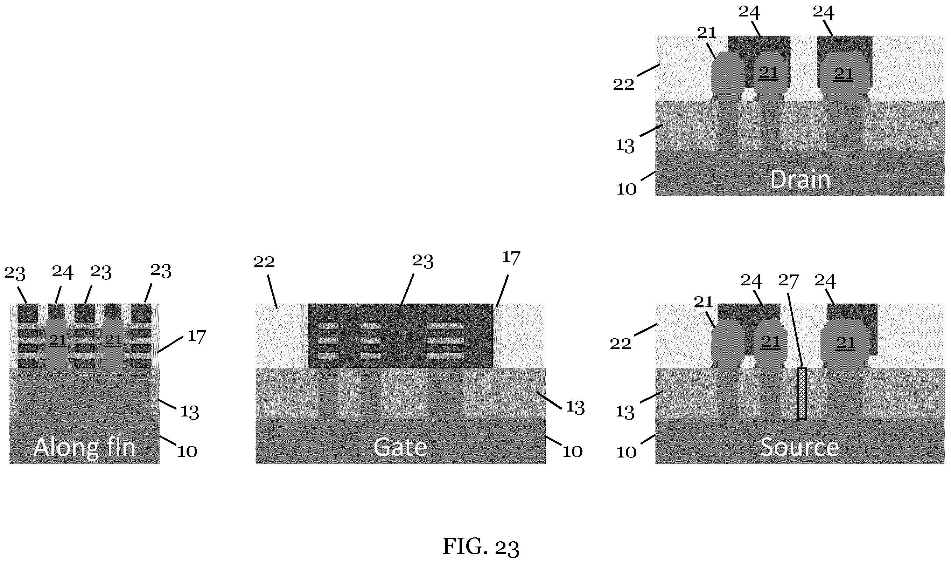

FIGS. 23 to 26 shows yet another alternative (e.g., to the method steps shown in FIGS. 19 to 23), where the STI layer 13 comprises an etch stop structure 27. This etch stop structure 27 can limit a lateral expansion of the recess in the STI layer 13.

The etch stop structure 27 can be a vertical isolation wall in the STI layer 13. For instance, the etch stop structure 27 can be made from SiGe or another material for which the etchant that is used for the recess 25 formation has a low etching rate.

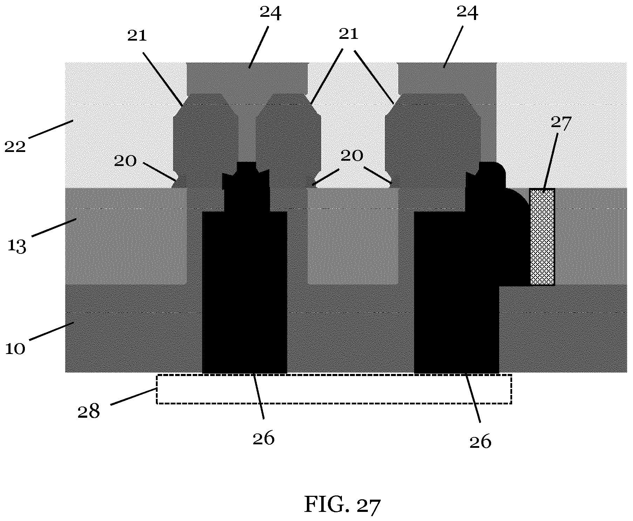

For instance, as shown in FIG. 27, a recess 25 below one of the fin structures 11 (in this example, the third fin structure 11) could be etched wider, e.g., removing the fin structure 11 material across the entire width of the fin structure 11.

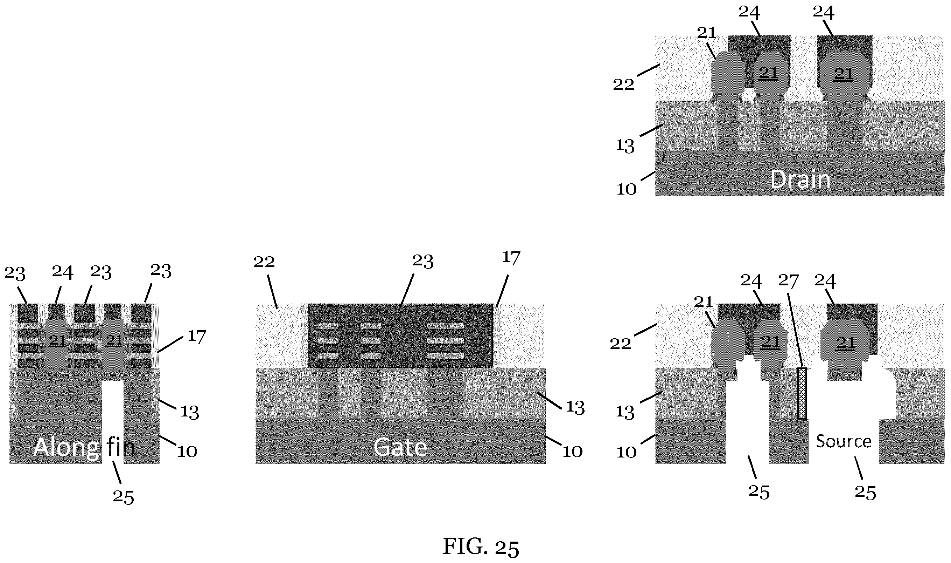

When subsequently removing the STI layer 13, the etch stop structure 27 can prevent an excessive expansion of the recess 25 in the STI layer 13, as shown in FIG. 25. In this way, for example, a merging of two adjacent recesses and/or a shorting of NMOS and PMOS devices can be prevented.

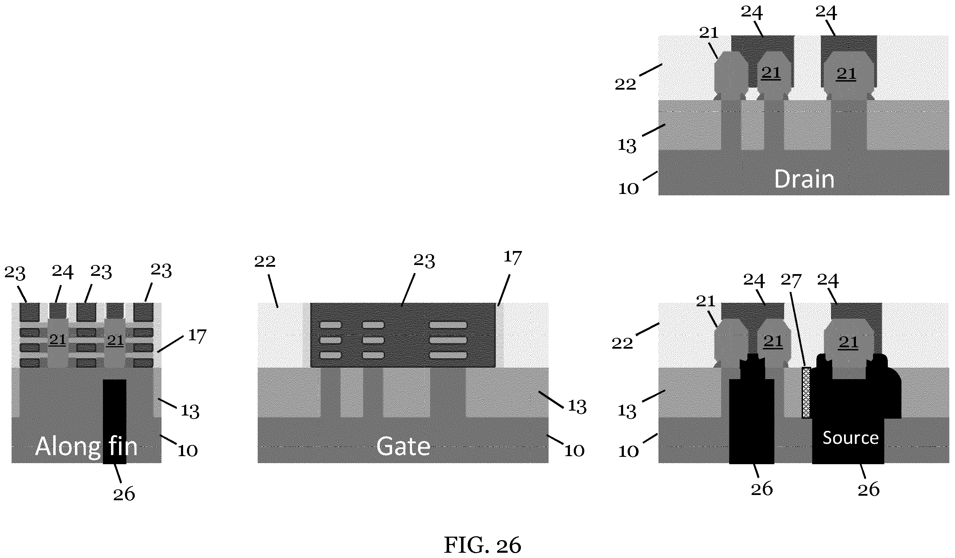

Furthermore, the wider recess 25 can reach a source structure 21 on two separate positions (e.g., on two opposite sides of the fin structure 11, as shown for the third fin structure 11 in FIG. 25). This can result in a via 26 which contacts the source structure 21 from two sides, as shown in FIG. 26.

Respective etch stop structures 27 could be arranged between each to adjacent fin structures 11 to limit the lateral expansion of the recess 25 respectively via 26.

The etch stop structure 27 can be an optional structure. For instance, a distance between adjacent transistors or fins can be big enough to accommodate some protrusion into the STI layer 13 during the etching of the recess 25 in the STI layer 13.

In the examples shown in FIGS. 16 to 26, respective recesses 25 are only formed below the source regions, wherein the resulting vias 26 contact the source structures 21. However, recesses 25 could alternatively or additionally also be formed below the drain regions and filled with the electrically conductive material to additionally or alternatively establish electrical contacts with the drain structures 25.

FIG. 27 shows a schematic diagram of a FET structure according to an embodiment. For instance, the FET structure was fabricated with a process flow as shown in FIGS. 1 to 26.

FIG. 27 shows the electrically conductive material of the vias 26 being connected to a signal or power metallization 28 which is formed on the second side of the substrate. The signal or power metallization 28 can comprise a signal and/or power lines or rails. For instance, the signal or power metallization comprise or forms a BS-PDN. It is noted that item 28 is only a schematic indication of the signal or power metallization 28 not at scale with the rest of the image. For instance, the substrate 10 might be much thicker and the vias 26 longer than indicated in FIG. 27.

For example, the signal or power metallization 28 can be formed by on the second side of the substrate by a layer by layer deposition process.

Furthermore, the FET structure in FIG. 27 features the etch stop structure 27 being arranged in a possible alternative position.

In summary, the FET structure and the fabrication method shown in FIGS. 1 to 27 provide several advantages: For instance, the epi growth of the S/D structures 21 being confined by the epi wall structure 18 during fabrication allows to prevent an epi merge (i.e., a merge of adjacent S/D structures 21) for multi-fin devices (e.g., for the S/D structures around the first and second fin structure 11). This can facilitate a direct connection of the via 26 to the sides of the epi structures and can enable a wrap-around contact of the metallization 24 (e.g., silicide) which is formed on top of the and on the sides of the S/D structures 21. Furthermore, the back-side-contact (i.e., the via 26) protruding through the STI layer 13 can provide the advantage that no separate sacrificial dielectric plug underneath the S/D structures 21 is required, which improves mechanical stress and ensures that the channels 12 are intact during contact formation. Furthermore, the via 26 landing on the side of the S/D structures 21 can increase a contacting area (compared to, e.g., only contacting to the bottom of the S/D structure 21). By means of the metallization structure 24, additionally the sides and the top of the S/D structure 21 can be contacted.

The FET structure may be comprised by a processor or processing circuitry (not shown) configured to perform, conduct or initiate various operations. The processing circuitry may comprise hardware and/or the processing circuitry may be controlled by software. The hardware may comprise analog circuitry or digital circuitry, or both analog and digital circuitry. The digital circuitry may comprise components such as application-specific integrated circuits (ASICs), field-programmable arrays (FPGAs), digital signal processors (DSPs), or multi-purpose processors. The device may further comprise memory circuitry, which stores one or more instruction(s) that can be executed by the processor or by the processing circuitry, in particular under control of the software. For instance, the memory circuitry may comprise a non-transitory storage medium storing executable software code which, when executed by the processor or the processing circuitry, causes the various operations of the device to be performed. In one embodiment, the processing circuitry comprises one or more processors and a non-transitory memory connected to the one or more processors.

The present disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A method of fabricating a field-effect transistor, FET, structure, comprising the steps of:
forming a first fin structure (11) on a first side of a substrate (10), wherein the first fin structure (11) extends along a channel direction, and wherein the first fin structure comprises at least one first channel (12);
forming a shallow trench isolation, STI, layer (13) on the first side of the substrate (10), wherein the STI layer (13) is arranged on opposite sides of the first fin structure (11);
forming a first source and/or drain structure (21) along the first fin structure (11), wherein the first source and/or drain structure (21) electrically contacts the at least one first channel (12);
etching a recess (25) from a second side of the substrate (10), which is opposite to the first side, wherein the recess (25) passes through a section of the STI layer (13), and wherein the recess (25) reaches the first source and/or drain structure (11); and
filling the recess (25) with an electrically conductive material to form a via (26), wherein the via (26) is in contact with the first source and/or drain structure (21).

2. The method of claim 1, further comprising the step of:
electrically connecting the electrically conductive material with a signal or power metallization (28) which is formed on the second side of the substrate (10).

3. The method of any one of the preceding claims,
wherein the via (26) is laterally offset from the first fin structure (11).

4. The method of any one of the preceding claims,
wherein the recess (25) reaches the first source and/or drain structure (21) on two separate positions.

5. The method of any one of the preceding claims, further comprising the step of:
forming a metallization structure (24) which at least partially surrounds the first source and/or drain structure (21), wherein the electrically conductive material is in electrical contact with the metallization structure (24).

6. The method of any one of the preceding claims,
wherein the first source and/or drain structure (21) is formed by:
- forming a cavity (19) in the first fin structure (11), wherein the cavity (19) interrupts the at least one channel (12) in a determined location along the channel direction, and
- forming the first source and/or drain structure (21) in the cavity.

7. The method of claim 6,
wherein the first source and/or drain structure (21) is formed by an epitaxial growth process.

8. The method of claim 7,
wherein a confinement structure is formed around the determined location, wherein the confinement structure limits the epitaxial growth of the source and/or drain structure (21).

9. The method of any one of the preceding claims,
wherein the recess (25) further passes through a section of the first fin structure (11) below the at least one channel (12).

10. The method of claim 9,
wherein a portion of the first fin structure (11) between the recess (25) and the first source and/or drain structure (21) stays intact.

11. The method of any one of the preceding claims,
wherein the STI layer (13) comprises an etch stop structure (27) which limits a lateral expansion of the recess (25) in the STI layer (13).

12. The method of any one of the preceding claims, further comprising:
forming at least a second fin structure (11) on the first side of a substrate (10), wherein the second fin structure (11) extends along the channel direction and comprises at least one second channel (12);
wherein the second fin structure (11) is arranged at a distance to the first fin structure (11), and wherein the second fin structure (11) is electrically isolated from the first fin structure (11) by the STI layer (13);
forming a second source and/or drain structure (21) along the second fin structure (11), wherein the second source and/or drain structure (21) electrically contacts the at least one second channel (12);
wherein the recess (25) additionally reaches the second source and/or drain structure (21).

13. The method of any one of claim 12,
wherein the via (26) is centrally arranged between the first fin structure (11) and the second fin structure (11).

14. The method of any one of claim 12 or 13,
wherein the first source and/or drain structure (21) and the second source and/or drain structure (21) are physically separated.

15. The method of claim 5 and any one of claims 12 to 14,
wherein the metallization structure (24) at least partially surrounds the first source and/or drain structure (21) and the second source and/or drain structure (21).

16. The method of any one of claims 12 to 15,
wherein a plurality of the second fin structures (11) is formed, wherein the first fin structure (11) and the plurality of second fin structures (11) are arranged in parallel on the first side of the substrate (10);
wherein the via (26) reaches a respective source and/or drain structure (21) of the first and of each second fin structure (11), or wherein a respective recess (25) is formed between each two adjacent fin structures (11) of the first and the second fin structures (11).

17. A field-effect transistor, FET, structure obtainable by the method according to any one of the preceding claims.

## Amended claims

### Amended claims in accordance with Rule 137(2) EPC.

1. A method of fabricating a field-effect transistor, FET, structure, comprising the steps of:
forming a first fin structure (11) on a first side of a substrate (10), wherein the first fin structure (11) extends along a channel direction, and wherein the first fin structure comprises at least one first channel (12);
forming a shallow trench isolation, STI, layer (13) on the first side of the substrate (10), wherein the STI layer (13) is arranged on opposite sides of the first fin structure (11),
forming a first source and/or drain structure (21) along the first fin structure (11) and on the first side of the substrate (10), wherein the first source and/or drain structure (21) electrically contacts the at least one first channel (12);
etching a recess (25) from a second side of the substrate (10), which is opposite to the first side, wherein the recess (25) passes through a section of the STI layer (13), and wherein the recess (25) reaches the first source and/or drain structure (11), wherein the recess (25) further passes through a section of the first fin structure (11) below the at least one channel (12), and wherein a portion of the first fin structure (11) between the recess (25) and the first source and/or drain structure (21) stays intact, and wherein the recess (25) is laterally offset from the first fin structure (11); and
filling the recess (25) with an electrically conductive material to form a via (26), wherein the via (26) is in contact with the first source and/or drain structure (21).

2. The method of claim 1, further comprising the step of:
electrically connecting the electrically conductive material with a signal or power metallization (28) which is formed on the second side of the substrate (10).

3. The method of any one of the preceding claims,
wherein the recess (25) reaches the first source and/or drain structure (21) on two opposite sides of the first fin structure (11).

4. The method of any one of the preceding claims, further comprising the step of:
forming a metallization structure (24) which at least partially surrounds the first source and/or drain structure (21),
wherein the electrically conductive material is in electrical contact with the metallization structure (24).

5. The method of any one of the preceding claims,
wherein the first source and/or drain structure (21) is formed by:
- forming a cavity (19) in the first fin structure (11), wherein the cavity (19) interrupts the at least one channel (12) in a determined location along the channel direction, and
- forming the first source and/or drain structure (21) in the cavity.

6. The method of claim 5,
wherein the first source and/or drain structure (21) is formed by an epitaxial growth process.

7. The method of claim 6,
wherein a confinement structure is formed around the determined location, wherein the confinement structure limits the epitaxial growth of the source and/or drain structure (21).

8. The method of any one of the preceding claims,
wherein the STI layer (13) comprises an etch stop structure (27) which limits a lateral expansion of the recess (25) in the STI layer (13).

9. The method of any one of the preceding claims, further comprising:
forming at least a second fin structure (11) on the first side of a substrate (10), wherein the second fin structure (11) extends along the channel direction and comprises at least one second channel (12);
wherein the second fin structure (11) is arranged next to the first fin structure (11) at a distance to the first fin structure (11), and wherein the second fin structure (11) is electrically isolated from the first fin structure (11) by the STI layer (13);
forming a second source and/or drain structure (21) along the second fin structure (11), wherein the second source and/or drain structure (21) electrically contacts the at least one second channel (12);
wherein the recess (25) additionally reaches the second source and/or drain structure (21).

10. The method of any one of claim 9,
wherein the via (26) is below the first fin structure (11) and the second fin structure (11) and is centrally arranged between the first fin structure (11) and the second fin structure (11).

11. The method of any one of claim 9 or 10,
wherein the first source and/or drain structure (21) and the second source and/or drain structure (21) are physically separated.

12. The method of claim 4 and any one of claims 9 to 11,
wherein the metallization structure (24) at least partially surrounds the first source and/or drain structure (21) and the second source and/or drain structure (21).

13. The method of any one of claims 9 to 12,
wherein a plurality of the second fin structures (11) is formed, wherein the first fin structure (11) and the plurality of second fin structures (11) are arranged in parallel on the first side of the substrate (10),
wherein the via (26) reaches a respective source and/or drain structure (21) of the first and of each second fin structure (11), or wherein a respective recess (25) is formed between each two adjacent fin structures (11) of the first and the second fin structures (11).
